Europäisches Patentamt

European Patent Office

Office européen des brevets

(11) Publication number: **0 262 268 B1**

## EUROPEAN PATENT SPECIFICATION

(45) Date of publication of patent specification: **30.12.92**  (51) Int. Cl.⁵: **G08B 29/00**

(21) Application number: **86307531.3**

(22) Date of filing: **01.10.86**

(54) **Alarm circuit testing.**

(43) Date of publication of application:
**06.04.88 Bulletin 88/14**

(45) Publication of the grant of the patent:
**30.12.92 Bulletin 92/53**

(84) Designated Contracting States:
**AT BE CH DE ES FR GR IT LI LU NL SE**

(56) References cited:
**DE-B- 1 218 909      US-A- 3 179 891**
**US-A- 4 032 909      US-A- 4 044 351**
**US-A- 4 329 643      US-A- 4 456 906**

(73) Proprietor: **Grant, David Peter**
**8 Andrew Avenue**
**Melling Liverpool, L31 1BL(GB)**

(72) Inventor: **Grant, David Peter**
**8 Andrew Avenue**
**Melling Liverpool, L31 1BL(GB)**

(74) Representative: **Lyons, Andrew John et al**
**ROYSTONS 531 Tower Building Water Street**
**Liverpool L3 1BA(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

# Description

This invention concerns electrical circuit testing, especially testing of electrical alarm circuits.

Conventional test meters are used for testing electrical circuitry for faults by measuring resistance, voltage or current between two points and comparing the measurement with that when the circuit is in good working order. The use of a test meter is fairly simple in domestic equipment such as a television set. However, problems arise when testing alarm circuits that have contacts at many points situated mainly some distance from a control unit for the alarm and often in separate rooms therefrom. A person on his own cannot test such alarm circuits since another person is required to make and break the contacts while the first person remains at the control panel to monitor the signal received and indicated by the test meter.

US-A-4032909 discloses in Figure 1 an arrangement for testing an alarm circuit, said alarm circuit including a control panel and one or more remote alarm sensors: comprising a transmitter unit for converting the audio alarm generated by the control panel into a radio frequency signal and means for transmitting said signal; and a receiver unit having means for receiving said signal transmitted from said unit, including means for converting said signal back into said audio alarm at said remote sensors for monitoring the audio alarm when acting on said remote sensors in turn which is indicative of the state of the remote sensor acted upon. The object of this invention is to provide a test meter that may be used by a single person to test electrical circuitry such as alarm circuitry particular wherein electrical contacts are remote from the customary testing place namely the control panel for the circuit.

According to this invention there is provided a test meter/display unit combination for testing an electrical alarm circuit, said electrical alarm circuit including a control box and one or more remote alarm contacts, comprising:

a test meter body for measuring ohmic resistance between two points of the electrical circuit in the control box when connected thereto;

said test meter body including means for converting ohmic resistance measured into a radio frequency signal and means for transmitting said signal from said test meter body; and

a receiver-display unit having means for receiving said signal transmitted from said test meter body transmitting means, including means for converting said signal back into said ohmic resistance measurement and means for displaying said resistance measurement at said remote alarm contacts for monitoring the ohmic resistance measurements displayed when acting on said remote contacts in turn which are indicative of the state of the remote alarm contact acted upon.

The present invention also provides a method of testing an electrical alarm circuit which includes a control box and one or more remote alarm contacts, comprising:

connecting a test meter to two points of the electrical alarm circuit in the control box for measuring ohmic resistance between said two points;

converting said test meter ohmic resistance measured into a radio frequency signal and transmitting said signal;

receiving said signal transmitted from said test meter at a receiver-display unit and converting said signal back into said ohmic resistance measurement and displaying said resistance measurement at said remote alarm contacts; and

acting on said remote contacts in turn and monitoring the ohmic resistance measurements displayed which are indicative of the state of the remote alarm contact being acted upon.

The test meter of the invention may, of course, be used as a conventional test meter with the detachable display unit attached to the meter body. However, for testing part of an electrical circuit remote from the conventional point of attachment of the test meter, such as the control panel for the circuit, the display unit is detached and taken to that remote part which can be operated and the effect on the meter at the control panel read on the detached display unit. Thus, one person can attach the test meter of the invention to a control panel or other suitable part of an electrical circuit to be tested, detach the display unit and take it to any part of the circuit and note any change in reading, for example, when an electrical contact is made or broken. The change in reading will identify if the contact is working correctly.

The display unit may have many suitable display system, such as a movable needle over a marked face, a light emitting diode display or preferably a liquid crystal display.

The meter body itself may include an on/off switch and may also include ohm range selection means such as a rotatable switch that can be turned to select an ohm range marked on the meter.

As most control panels/boxes are at least partly of metal, such as steel, it may be advantageous to provide the meter body with magnetic attachment means, such as one or more magnetic strips on the back of the body whereby it can be attached to say a steel panel or box.

In practice then one person may with the test meter of the invention check electrical circuitry that extends some way from the control point of the circuitry. This is particularly useful for checking alarm circuits and for this purpose it is envisaged that the meter transmitter/receiver be able to operate over distances as much as 1000m.

The invention will now be further described by way of example only, with reference to the accompanying drawings in which:-

Figure 1 shows a test meter of the invention; and

Figure 2 shows schematically the components of a test meter of the invention;

Figure 3 shows a resistance measuring system for a test meter of the invention; and

Figure 4 shows schematically use of the meter of the invention.

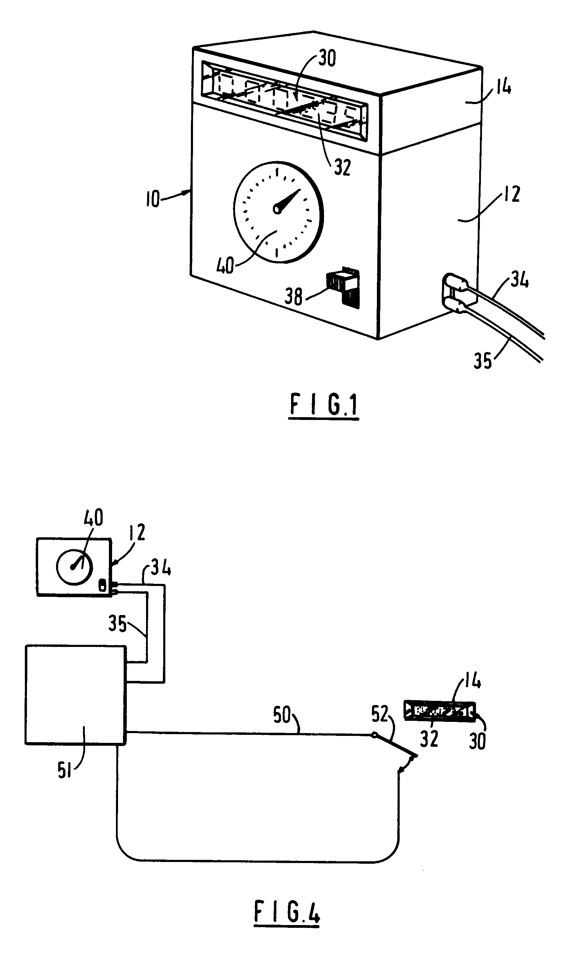

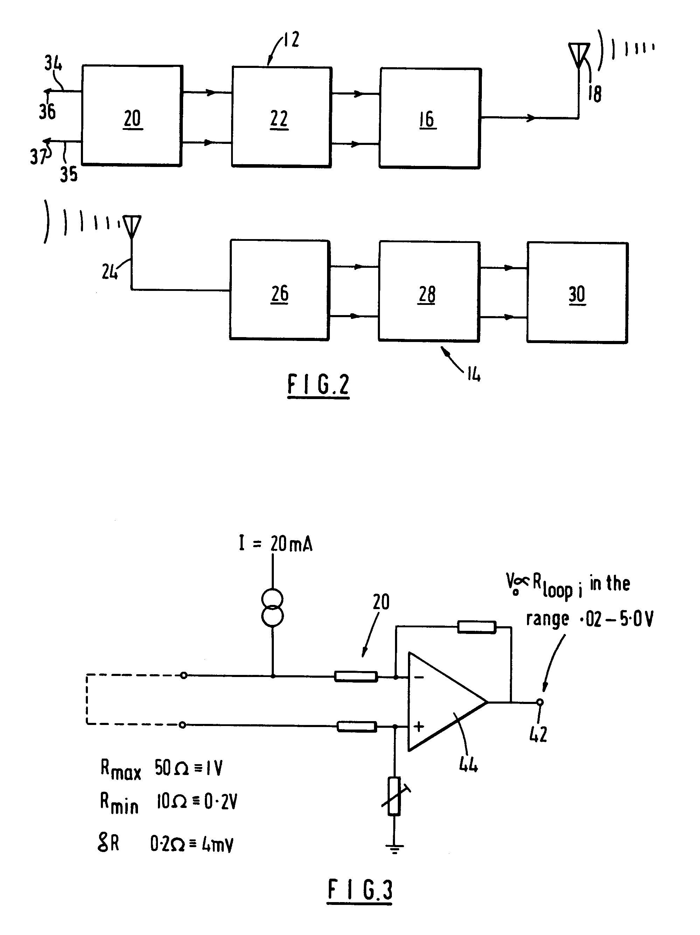

Referring to Figures 1 and 2 of the drawings, a test meter 10 comprises a main body 12 and a detachable display unit 14. The body 12 and display unit 14 have mutually engaging electrical contacts for conventional use of the meter with the display unit attached to the body. Those contacts may provide the means for retaining the display unit on the body or other or additional releasable engagement means may be provided.

The body 12 contains a radio transmitter 16, an aerial 18 and electronic circuitry for converting a resistance measurement into a radio frequency signal. The circuitry includes a resistance measuring system 20 and a data encoder 22 for converting the resistance measurement into radio frequency signals. The display unit 14 includes an aerial 24 for receiving the radio frequency signal from the meter body and electronic circuitry for converting the signal back into the resistance measurement. That circuitry includes a radio frequency receiver 26 and a data decoder 28. The measurement is then shown on liquid crystal display 30 through a glass window 32. Any other suitable display means may, of course, be used.

The resistance measuring system preferably includes a constant current circuit based on a differential amplifier 44 as shown in Figure 3, wherein the dotted lines represent the circuit under test and the connection 42 is to the data encoder.

Connection of the meter to an electrical circuit is by means of wires 34 and 35 via probes 36 and 37 or alternatively via clip type endings.

The meter body is shown with an on/off switch 38 for the battery supply. The battery is preferably rechargeable so that means for connection thereof to a power supply may be provided. Also shown is a dial 40 by which the ohm range to be measured can be selected. In use (see Figure 4 of the drawings), the meter 10 is connected to the control panel 51 of an electrical circuit 50, say an electrical alarm circuit that has a series of electrical contacts 52 that, for example, are made when a door is closed but broken when the door is opened. The door could be in another room or merely several yards away from the control panel 51 for the circuit 50 so that a second person would be needed using a conventional test meter, one person watching the meter whilst the other opens and closes the door. With the test meter of the invention, however, only one person is required who connects the meter to the control panel.

switches it on and detaches the display unit. That person can then take the display unit to the door and open and close the door while watching the display unit. He can then tell by the resistance readings that he obtains on the display unit if the contact is working correctly. A whole alarm circuit can be tested in this way by one person without him ever having to return to the control panel.

This is almost certainly going to save time and expense as only one man can test an entire extensive electrical circuit relatively quickly.

## Claims

1. A test meter/display unit combination (10) for testing an electrical alarm circuit, said electrical alarm circuit including a control box and one or more remote alarm contacts, comprising:

   a test meter body (12) for measuring ohmic resistance between two points of the electrical circuit in the control box when connected thereto;

   said test meter body including means (20, 22) for converting ohmic resistance measured into a radio frequency signal and means (16, 18) for transmitting said signal from said test meter body; and

   a receiver-display unit (14) having means (24) for receiving said signal transmitted from said test meter body transmitting means, including means (26, 28) for converting said signal back into said ohmic resistance measurement and means (30, 32) for displaying said resistance measurement at said remote alarm contacts for monitoring the ohmic resistance measurements displayed when acting on said remote contacts in turn which are indicative of the state of the remote alarm contact acted upon.

2. A combination as claimed in claim 1, characterised in that test meter/display unit combination is powered by battery.

3. A combination as claimed in claim 1 or 2, characterised in that the display unit (14) display comprises a liquid crystal display (30,32).

4. A combination as claimed in claim 1, 2 or 3, characterised in that the meter body (12) is provided with magnetic attachment means, whereby it can be attached to say a steel panel or box.

5. A method of testing an electrical alarm circuit which includes a control box and one or more remote alarm contact, comprising:

connecting a test meter (12) to two points of the electrical alarm circuit in the control box for measuring ohmic resistance between said two points;

converting said test meter ohmic resistance measured into a radio frequency signal and transmitting said signal;

receiving said signal transmitted from said test meter at a receiver-display unit (14) and converting said signal back into said ohmic resistance measurement and displaying said resistance measurement at said remote alarm contacts; and

acting on said remote contacts in turn and monitoring the ohmic resistance measurements displayed which are indicative of the state of the remote alarm contact being acted upon.

## Patentansprüche

1. Kombination (10) aus einem Prüfgerät und einer Anzeigeeinheit zum Testen einer elektrischen Alarmschaltung (50), wobei die elektrische Alarmschaltung (50) eine Steuerbox (51) und eine oder mehrere entfernte Alarmkontakte aufweist, mit
einem Prüfgerätekörper (12) für die Messung des Ohm'schen Widerstandes zwischen zwei Punkten der elektrischen Alarmschaltung (50), wenn diese daran angeschlossen sind;
Einrichtungen (20, 22) im Prüfgerätekörper (12) zum Umwandeln des gemessenen Ohm'schen Widerstandes in ein hochfrequentes Signal und Einrichtungen (16, 18) zum Senden dieses hochfrequenten Signals vom Prüfgerätekörper (12); und
einer Empfangsanzeigeeinheit (14) mit Einrichtungen (24) zum Empfangen des von der Sendeeinrichtung des Prüfgerätekörpers (12) gesendeten Signals und Einrichtungen (26, 28) zum Umsetzen dieses Signals in Ohm'sche Widerstandsmeßwerte und Einrichtungen (30, 32) zum Anzeigen dieses Widerstandsmeßwertes an den entfernten Alarmkontakten und zum Überwachen dieses angezeigten Widerstandsmeßwertes, ob sich der Zustand an den entfernten Kontakten verändert.

2. Kombination nach Anspruch 1, dadurch gekennzeichnet, daß die Kombination (10) aus dem Prüfgerät und der Anzeigeeinheit durch eine Batterie gespeist wird.

3. Kombination nach Anspruch 1 oder 2, dadurch gekennzeichnet, daß die Anzeigeeinheit (14) eine Flüssigkeitskristallanzeige (30, 32) aufweist.

4. Kombination nach einem der Ansprüche 1 bis 3, dadurch gekennzeichnet, daß das Prüfgerätekörper (12) mit einer magnetischen Befestigungseinrichtung versehen ist, die an eine Stahlkonsole oder an einem Stahlgehäuse befestigt werden kann.

5. Verfahren zum Testen einer elektrischen Alarmschaltung (50), die eine Steuerbox (51) und einen oder mehrere entfernte Alarmkontakte aufweist, indem
ein Prüfgerät (12) an zwei Punkten der elektrischen Alarmschaltung (50) in der Steuerbox (51) zum Messen des Ohm'schen Widerstandes zwischen diesen beiden Punkten angeschlossen wird;
das Prüfgerät (12) den gemessenen Ohm'schen Widerstand in ein hochfrequentes Signal umwandelt und dieses Signal sendet;
dieses von dem Prüfgerät (12) gesendete Signal von einer Empfangsanzeigeeinheit (14) empfangen wird und dieses Signal zurück in ein Ohm'sches Meßwertsignal umgewandelt wird und der Widerstandswert der entfernten Alarmkontakte angezeigt wird; und
der angezeigte Ohm'sche Widerstandsmeßwert überprüft wird, ob sich der Zustand an den entfernten Kontakten verändert.

## Revendications

1. Combinaison dispositif de mesure de tests / unité affichage (10) destinée à tester un circuit d'alarme électrique, lequel inclut un boîtier de commande et un ou plusieurs interrupteurs d'alarme à distance, comprenant :

un boîtier de dispositif de mesure de tests (12) pour mesurer la résistance ohmique entre deux points du circuit électrique dans le boîtier de commande lorsque le boîtier du dispositif de tests est connecté au boîtier de commande;

ce boîtier du dispositif de mesure de tests (12) comportant lui-même des moyens (20,22) pour convertir la résistance ohmique mesurée en un signal à haute fréquence et des moyens (16,18) pour transmettre ce signal à partir du boîtier du dispositif de mesure de tests ;

une unité de réception et d'affichage (14) dotée de dispositifs (24) pour recevoir ledit signal transmis à partir dudit boîtier du dispositif de mesure de tests, comportant des dispositifs (26, 28) pour reconvertir le signal et une mesure de la résistance ohmique et des dispositifs (30, 32) pour afficher la mesure de la résistance au niveau desdits interrupteurs d'alarme à distance pour contrôler les mesures de la résistance ohmique qui sont affichées en actionnant alternativement lesdits interrupteurs à distance et qui sont représentatives de l'état de l'interrupteur d'alarme à distance qui est actionné.

2. Combinaison selon la revendication 1, caractérisée en ce que la combinaison dispositif de mesure de tests / unité d'affichage est alimentée par une batterie.

3. Combinaison selon la revendication 1 ou 2, caractérisée en ce que l'affichage de l'unité d'affichage (14) comporte un affichage à cristaux liquides (30, 32).

4. Combinaison selon la revendication 1, 2 ou 3, caractérisée en ce que le boîtier du dispositif de mesure (12) est doté de moyens de fixation magnétique et peut, de ce fait, être fixé sur un tableau ou un boîtier métalliques.

5. Méthode pour tester un circuit d'alarme électrique incluant un boîtier de commande et un ou plusieurs interrupteurs d'alarme à distance, que consiste :

à connecter un dispositif de mesure de tests (12) à deux points du circuit d'alarme électrique dans le boîtier de commande pour mesurer la résistance ohmique entre ces deux points ;

à convertir la résistance ohmique mesurée à l'aide du dispositif de mesure de tests en un signal à haute fréquence et à le transmettre ;

à recevoir le signal transmis par ledit dispositif de mesure de tests au niveau d'une unité de réception et d'affichage (14) et à reconvertir ce signal en ladite mesure de la résistance ohmique et à afficher cette mesure de la résistance au niveau desdits interrupteurs d'alarme à distance ;

à actionner alternativement lesdits interrupteurs à distance et à contrôler les mesures de la résistance ohmique affichées qui sont représentatives de l'état de l'interrupteur d'alarme à distance qui est actionné.

F I G.1

F I G.4

F I G.2

$I = 20\,mA$

$V_o \propto R_{loop\,i}$ in the range $\cdot02 - 5\cdot0V$

$R_{max}$   $50\,\Omega \equiv 1V$

$R_{min}$   $10\,\Omega \equiv 0\cdot2V$

$\delta R$   $0\cdot2\,\Omega \equiv 4mV$

F I G.3

7